(19) Europäisches Patentamt
European Patent Office
Office européen des brevets

(11) EP 4 204 825 B1

# (12) FASCICULE DE BREVET EUROPEEN

(45) Date de publication et mention de la délivrance du brevet:
**23.07.2025 Bulletin 2025/30**

(21) Numéro de dépôt: **21799088.6**

(22) Date de dépôt: **07.10.2021**

(51) Classification Internationale des Brevets (IPC):
***G01R 27/16*** *(2006.01)* ***F16L 53/35*** *(2018.01)*
***H05B 3/00*** *(2006.01)*

(52) Classification Coopérative des Brevets (CPC):
**G01R 27/16; H05B 3/58;** F16L 53/37; G01R 27/02; H05B 2203/021; H05B 2203/022; H05B 2214/03

(86) Numéro de dépôt international:
**PCT/FR2021/051737**

(87) Numéro de publication internationale:
**WO 2022/074335 (14.04.2022 Gazette 2022/15)**

(54) **PROCÉDÉ DE DÉTERMINATION DE LA RÉSISTANCE ÉLECTRIQUE LINÉIQUE EN RÉGIME ALTERNATIF D'UNE CONDUITE EN ACIER ET DISPOSITIF DE MISE EN OEUVRE D'UN TEL PROCÉDÉ**

VERFAHREN ZUR BESTIMMUNG DES LINEAREN ELEKTRISCHEN WECHSELSTROMWIDERSTANDES EINES STAHLROHRES UND VORRICHTUNG ZUR DURCHFÜHRUNG EINES SOLCHEN VERFAHRENS

METHOD FOR DETERMINING THE LINEAR AC ELECTRICAL RESISTANCE OF A STEEL PIPE AND DEVICE FOR IMPLEMENTING SUCH A METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.10.2020 FR 2010329**

(43) Date de publication de la demande:
**05.07.2023 Bulletin 2023/27**

(73) Titulaire: **SAIPEM S.A.**
**78180 Montigny Le Bretonneux (FR)**

(72) Inventeur: **HALLOT, Raymond**
**78960 VOISINS LE BRETONNEUX (FR)**

(74) Mandataire: **Cabinet Beau de Loménie**
**103, rue de Grenelle**
**75340 Paris Cedex 07 (FR)**

(56) Documents cités:
**EP-A1- 0 375 375**
**FR-A1- 3 083 841**
**US-A1- 2002 105 333**
**US-A1- 2004 149 443**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 4 204 825 B1

## Description

### Domaine Technique

L'invention se rapporte au domaine général de la caractérisation de conduites en acier utilisées pour le transport de fluides, notamment de pétrole et de gaz. Elle concerne plus précisément un procédé de détermination de la résistance électrique linéique en régime alternatif d'une conduite en acier.

### Technique antérieure

Dans un même champ de production d'hydrocarbures offshore, il est courant d'exploiter plusieurs puits qui peuvent être séparés les uns des autres de plusieurs kilomètres, voire dizaines de kilomètres. Les fluides issus de ces différents puits doivent être collectés par des conduites sous-marines métalliques (typiquement en acier) posées au fond de la mer et transférés par des conduites de liaison fond/surface vers une installation de surface, par exemple une plateforme, un navire ou un point de collecte terrestre, qui va les recueillir pour les stocker (et éventuellement les traiter).

Les fluides issus des puits de production ont tendance à se refroidir rapidement en parcourant les nombreux kilomètres de conduites sous-marines ou lors d'arrêts de production. Or, si aucune disposition n'est prise pour conserver une température de seuil minimale à l'intérieur de ces conduites, le risque est important que les molécules de gaz, notamment le méthane, contenus dans les fluides transportés se combinent aux molécules d'eau pour former, à basse température, des cristaux d'hydrates. Ces derniers peuvent coller aux parois, s'y agglomérer et conduire à la formation de bouchons capables de bloquer la circulation des fluides à l'intérieur des conduites. De même, la solubilité dans le pétrole des composés à haut poids moléculaires, comme les paraffines ou les asphaltènes, diminue lorsque la température baisse, ce qui donne naissance à des dépôts solides capables eux-aussi de bloquer la circulation.

Dans le cas de conduites sous-marines dites « à simple enveloppe », il est connu de recourir à une solution active de chauffage. La solution la plus répandue consiste à chauffer la conduite sous-marine par l'application d'un courant électrique alternatif directement sur l'enveloppe interne en acier de la conduite, cette enveloppe étant reliée à chaque extrémité de la conduite à un câble électrique. L'enveloppe interne n'est pas isolée électriquement de l'eau de mer dans laquelle la conduite est immergée, conduisant à de forts courants circulant dans cette eau de mer et réduisant fortement l'efficacité de la solution.

Dans le cas de conduites sous-marines dites « à double enveloppe » de type « Pipe In Pipe » ou PIP dans lesquelles une enveloppe interne transporte les fluides et une enveloppe externe coaxiale à l'enveloppe interne est en contact avec l'eau de mer, il est également connu de chauffer l'enveloppe interne de la conduite par application d'un courant électrique alternatif directement sur l'enveloppe interne en acier de la conduite, l'enveloppe externe également réalisée en acier étant utilisée comme un conducteur pour le chemin retour du courant électrique.

Le courant électrique alternatif qui parcourt l'enveloppe interne permet ainsi de chauffer celle-ci par effet de Joule. Plus précisément, le chauffage de l'enveloppe interne est produit par effet Joule par le courant qui la traverse ; la chaleur produite est en grande partie transmise aux fluides dans l'enveloppe interne, les pertes thermiques au travers de l'isolant remplissant l'espace annulaire entre l'enveloppe interne et l'enveloppe externe étant relativement réduites. Cette solution de chauffage électrique est appelée en anglais « Direct Electrical Heating » (ou DEH) pour chauffage électrique direct.

Quelle que soit le type de conduite (à simple ou à double enveloppe), il est nécessaire de s'assurer avant la mise en service que la puissance de chauffe linéique en fonctionnement sera suffisamment homogène tout le long de la conduite. En effet, la puissance de chauffe d'un tronçon de conduite étant égale à sa résistance électrique en régime alternatif multipliée par le carré du courant efficace qui le traverse, une résistance électrique linéique en régime alternatif hors tolérance sur l'un des tronçons de la conduite conduira à une puissance de chauffe hors tolérance en conditions de fonctionnement.

La résistance électrique linéique en régime alternatif d'une conduite en acier dépend de nombreux facteurs et elle peut varier d'un tronçon de conduite à un autre, en particulier au sein d'un même lot de fabrication. Aussi, il est apparu crucial de pouvoir déterminer la résistance électrique linéique en régime alternatif à réception des lots de tronçons de conduites.

A cet effet, l'une des méthodes connues pour mesurer la résistance électrique linéique en régime alternatif des tronçons de conduite est basée sur l'alimentation électrique directe aux deux extrémités de chaque tronçon de conduite au moyen d'une source électronique de puissance dédiée. On pourra se référer notamment à la publication intitulée « Electromagnetic Modelling for Electrical Heating of Pipelines » et publiée en 2007 par « International Society of Offshore and Polar Engineers » (ISOPE-I-07-378).

Cette méthode présente cependant de nombreux inconvénients, dont un temps de cycle de mesure qui est relativement long (environ 15 min pour un tronçon de conduite d'une longueur de 12 m). Par ailleurs, cette méthode nécessite un meulage du tronçon de conduite au niveau des points de raccordement à la source électronique de puissance. En outre, le matériel nécessaire à cette mesure (en particulier la source de puissance) est assez volumineux.

On connaît également du document EP 0,375,375 un procédé de détermination de la résistance électrique linéique en régime alternatif d'une conduite en acier.

Exposé de l'invention

L'invention a donc pour objet de proposer un procédé de détermination de la résistance électrique linéique en régime alternatif d'une conduite en acier qui ne présente pas les inconvénients précités.

Conformément à l'invention, ce but est atteint grâce à un procédé de détermination de la résistance électrique linéique en régime alternatif d'une conduite en acier tel que défini dans la revendication indépendante 1.

Le procédé selon l'invention est remarquable en ce qu'il prévoit de déterminer la résistance électrique linéique en régime alternatif (AC) d'une portion de conduite en générant un champ magnétique à fréquence prédéterminée capable d'induire un courant dans l'épaisseur de la conduite. Il est notamment possible de réaliser une mesure locale de la résistance électrique linéique AC ou bien de balayer l'ensemble de la conduite en déplaçant la bobine d'induction le long de la conduite. Dans ce cas, le temps nécessaire à la détermination de la résistance électrique linéique AC peut être considérablement réduit par rapport à la méthode connue de l'art antérieur (typiquement 5 min pour une conduite d'une longueur de 12 m).

De plus, le procédé selon l'invention ne nécessite aucun meulage (ou autre opération) de la conduite et l'équipement nécessaire à sa mise en œuvre est très peu encombrant. En outre, le procédé selon l'invention permet de réaliser une mesure de la résistance électrique linéique AC aussi bien sur la face externe de la conduite que sur sa face interne.

Selon l'invention, la résistance électrique linéique en régime alternatif de la portion de conduite est déterminée à l'étape d) par l'équation : $R_{AC_DEH} = (2 \times \Pi_{heat_JIMP}) / (\pi \times OD \times H_{JIMP})^2$ ; dans laquelle $R_{AC_DEH}$ est la résistance électrique linéique en régime alternatif, $\Pi_{heat_JIMP}$ est la puissance active dissipée par unité de longueur de la conduite, OD est le diamètre de la conduite, et $H_{JIMP}$ est l'amplitude du champ magnétique produit.

De façon avantageuse également, la fréquence du champ magnétique produit à l'étape a) peut être variée en continu afin de déterminer la résistance électrique linéique en régime alternatif de la portion de conduite à différentes fréquences. Selon une application, les étapes a) à d) sont répétées sur toute la longueur de la conduite en déplaçant la bobine d'induction le long de la conduite.

La bobine d'induction de l'étape a) peut être disposée à l'intérieur de la conduite afin de déterminer la résistance électrique linéique AC de la face interne de la conduite. Alternativement, elle peut être disposée à l'extérieur de la conduite afin de déterminer la résistance électrique linéique AC de la face externe de la conduite.

La fréquence du champ magnétique produit à l'étape a) peut être comprise entre 5 Hz et 10 kHz.

L'invention a également pour objet un dispositif pour la mise en œuvre du procédé tel que défini précédemment, ledit dispositif étant tel que défini dans la revendication indépendante 7.

La culasse peut comprendre un corps tubulaire concentrique à la bobine d'induction qui se termine à chaque extrémité par une collerette annulaire délimitant un entrefer avec la portion de la conduite.

La bobine d'induction peut être réalisée par un enroulement d'un fil conducteur avec un pas variable sur la longueur de ladite bobine d'induction afin de compenser les effets de bord. Alternativement, la bobine d'induction peut être réalisée par un enroulement en plusieurs couches de fils conducteurs sur tout ou partie de sa longueur.

De préférence, le dispositif comprend en outre des moyens pour minimiser l'influence des effets de bord sur la qualité des mesures. Dans ce cas, le dispositif peut ainsi comprendre des plaquettes en matériau ferromagnétique qui sont aptes à glisser radialement sur chaque collerette de la culasse afin de venir en contact de la surface de la portion de conduite pour minimiser l'influence des effets de bord sur la qualité des mesures. Alternativement, le dispositif peut comprendre des lames flexibles feuilletées en matériau ferromagnétique qui sont positionnées en étoile autour de la conduite et à chaque extrémité du corps tubulaire de la bobine d'induction afin de venir en contact de la surface de la portion de conduite pour minimiser l'influence des effets de bord sur la qualité des mesures.

Brève description des dessins

[Fig. 1] La figure 1 est une vue schématique d'un exemple de dispositif pour la mise en œuvre du procédé selon l'invention.

[Fig. 2] La figure 2 est une vue schématique d'un autre exemple de dispositif pour la mise en œuvre du procédé selon l'invention.

[Fig. 3] La figure 3 représente un exemple de distribution du champ magnétique produit au cours du procédé selon l'invention dans la bobine d'induction et dans une portion de conduite.

[Fig. 4] La figure 4 représente un exemple de distribution de la puissance active volumique dissipée dans la bobine d'induction et dans une portion de conduite soumise au procédé selon l'invention.

[Fig. 5] La figure 5 est une courbe montrant un exemple de résistance électrique linéique en régime alternatif en fonction de l'amplitude du champ magnétique de la face externe d'une portion de conduite soumise au procédé selon l'invention.

[Fig. 6] La figure 6 est une courbe montrant un exemple de résistance électrique linéique en régime alternatif en fonction de l'amplitude du champ magnétique de la face interne d'une portion de conduite soumise au procédé selon l'invention.

[Fig. 7A] La figure 7A représente en coupe longitudinale une variante du dispositif selon l'invention muni d'un exemple de système pour minimiser l'influence des effets de bord sur la qualité de la mesure.

[Fig. 7B] La figure 7B est une vue en coupe transversale du dispositif de la figure 7A.

**[Fig. 8A]** La figure 8A représente en coupe longitudinale une autre variante du dispositif selon l'invention muni d'un autre exemple de système pour minimiser l'influence des effets de bord sur la qualité de la mesure.

[Fig. 8B] La figure 8B est une vue en coupe transversale du dispositif de la figure 8A.

[Fig. 9] La figure 9 représente une variante du système des figures 8A et 8B pour minimiser l'influence des effets de bord sur la qualité de la mesure.

[Fig. 10] La figure 10 représente une autre variante du système des figures 8A et 8B pour minimiser l'influence des effets de bord sur la qualité de la mesure.

[Fig. 11] La figure 11 représente encore une autre variante du système des figures 8A et 8B pour minimiser l'influence des effets de bord sur la qualité de la mesure.

[Fig. 12] La figure 12 représente encore une autre variante du système des figures 8A et 8B pour minimiser l'influence des effets de bord sur la qualité de la mesure.

Description des modes de réalisation

Le procédé selon l'invention s'applique à toute conduite sous-marine (à simple ou double enveloppe) réalisée en acier et destinée à transporter des fluides tels que du pétrole et du gaz.

Le procédé selon l'invention s'applique plus particulièrement aux conduites sous-marines en acier (notamment mais non exclusivement en acier au carbone) qui sont soumises à un chauffage électrique de type « Direct Electrical Heating » (ou DEH).

Ce type de chauffage électrique consiste à appliquer un courant électrique alternatif sur l'enveloppe à chauffer. Le chauffage de l'enveloppe est produit par effet Joule par le courant qui la traverse, la chaleur produite étant en grande partie transmise aux fluides circulant dans l'enveloppe.

Le procédé selon l'invention vise à déterminer la résistance électrique linéique en régime alternatif (AC) d'une telle conduite au moyen d'un dispositif tel que celui représenté sur les figures 1 et 2.

Dans ces deux modes de réalisation, le dispositif est formé par un assemblage d'une bobine d'induction (ou solénoïde) destinée à être alimentée par un courant alternatif et d'une culasse en matériau ferromagnétique.

Dans le mode de réalisation de la figure 1, le dispositif 2 selon l'invention est disposé autour d'une portion de conduite 4 (pouvant être l'enveloppe interne d'une conduite à double enveloppe ou l'enveloppe dans le cas d'une conduite à simple enveloppe) de façon à déterminer la résistance électrique linéique AC de la face externe de la portion de conduite.

Le dispositif comprend une bobine d'induction 6 qui centrée sur l'axe longitudinal X-X de la conduite 4, et une culasse 8 en matériau ferromagnétique à l'intérieur de laquelle est montée la bobine d'induction 6 et qui permet de confiner le champ magnétique sur une surface prédéfinie de la portion de conduite.

Plus précisément, la culasse 8 comprend un corps tubulaire 8a qui est centré sur l'axe longitudinal X-X de la conduite 4 et qui se termine à chaque extrémité longitudinale par une collerette (ou joue) annulaire 8b tournée vers l'intérieur. Ces collerettes 8b sont positionnées en regard de la face externe de la portion de conduite afin de confiner le champ magnétique produit par la bobine d'induction dans un espace annulaire délimité et prédéfini, en particulier sur une longueur précise de la conduite.

La culasse 8 est réalisée dans un matériau ferromagnétique, tel que par exemple du ferrite ou en acier électrique feuilleté.

Quant à la bobine d'induction 6, elle est réalisée par un enroulement d'un fil conducteur, par exemple en cuivre ou en aluminium, cet enroulement pouvant être monocouche ou multicouches.

Par ailleurs, afin de minimiser les effets de bord, l'enroulement du fil conducteur peut présenter un pas qui varie sur la longueur de ladite bobine d'induction avec une densité de fil conducteur plus importante aux deux extrémités longitudinales du corps tubulaire 8a de la culasse qu'au centre de celui-ci. Alternativement, pour obtenir le même effet, l'enroulement de fil conducteur pourra se faire en plusieurs couches à ces deux extrémités longitudinales et être monocouche au centre.

De plus, la bobine d'induction 6 est raccordée à une source de courant alternatif (non représentée sur les figures).

Enfin, le dispositif 2 selon l'invention pourra comporter des moyens pour se déplacer sur toute la longueur de la conduite afin de réaliser une mesure de la résistance électrique AC de toute la conduite. Ces moyens, non représentés sur la figure, peuvent comprendre des patins en matière plastique ou bien des galets disposés sur la face extérieure des deux collerettes 8b dans le but de centrer le dispositif sur la conduite tout en permettant une translation axiale sans friction excessive.

Dans le mode de réalisation de la figure 2, le dispositif 2' selon l'invention est disposé à l'intérieur d'une portion de conduite 4 (pouvant être l'enveloppe externe d'une conduite à double enveloppe) de façon à déterminer la résistance électrique AC de la face interne de la portion de conduite.

Par rapport au mode de réalisation de la figure 1, il résulte de cette disposition que la culasse 8' comprend un corps tubulaire 8'a qui se termine à chaque extrémité longitudinale par des collerettes 8'b tournées vers l'extérieur. Ces collerettes 8b sont positionnées en regard de la face interne de la portion de conduite et confinent le champ magnétique produit par la bobine d'induction dans un espace annulaire délimité et prédéfini, en particulier sur une longueur précise de la conduite.

Quant à la bobine d'induction 6', elle est semblable à celle du mode de réalisation de la figure 1.

Le procédé selon l'invention est mis en œuvre par un tel dispositif 2, 2' et prévoit les étapes suivantes.

La bobine d'induction 6, 6' du dispositif est alimentée en courant alternatif à une fréquence f prédéterminée. L'alimentation de la bobine d'induction génère un champ magnétique à une fréquence prédéfinie, ce champ magnétique induisant un courant dans l'épaisseur de la portion de conduite soumise au dispositif selon l'invention (sur sa face interne ou sa face externe).

Plus précisément, lorsque la conduite est excitée par une bobine d'induction JIMP de longueur lgJIMP et comportant n spires parcourues chacune par un courant i, un courant orbital $I_{JIMP}$ se développe par induction à la surface de la conduite dans une portion de conduite de longueur $lg_{JIMP}$ et d'épaisseur de peau $\delta_{JIMP}$ donnée par l'équation suivante :

[Math. 1]

$$\delta_{JIMP} = \sqrt{\frac{\rho}{\pi . f . \mu}}$$

Dans cette équation, f est la fréquence du courant alternatif, $\rho$ est la résistivité électrique du matériau de la conduite, et $\mu$ est la perméabilité magnétique du matériau de la conduite.

L'amplitude du champ magnétique $H_{JIMP}$ sous la bobine d'induction est théoriquement constante et est donnée par l'équation suivante :

[Math. 2]

$$H_{JIMP} = \frac{n \cdot i \cdot \sqrt{2}}{lg_{JIMP}} = \frac{I_{JIM} \cdot \sqrt{2}}{lg_{JIMP}}$$

La puissance active $P_{heat_JIMP}$ dissipée par la portion de conduite soumise au champ magnétique est donnée par

l'équation suivante :

[Math. 3]

$$P_{heat_JIMP} = \rho \cdot \frac{\pi \cdot OD}{lg_{JIMP} \cdot \delta_{JIMP}} \cdot I_{JIM}^{2} = \rho \cdot \frac{\pi \cdot OD}{lg_{JIMP} \cdot \delta_{JIMP}} \cdot \left( H_{JIMP} \cdot \frac{lg_{JIMP}}{\sqrt{2}} \right)^{2}$$

Dans cette équation, OD est le diamètre de la conduite (à savoir le diamètre extérieur de la conduite si le dispositif est disposé autour de la conduite ou le diamètre intérieur de la conduite si le dispositif est disposé à l'intérieur de la conduite).

On en déduit que l'épaisseur de peau $\delta_{JIMP}$ du courant orbital à la surface de la conduite est donnée par l'équation :

[Math. 4]

$$\delta_{JIMP} = \frac{\pi \cdot OD \cdot \rho \cdot H_{JIMP}^{2}}{2 \cdot \Pi_{heat_JIMP}}$$

Dans cette équation, $\Pi_{heat_JIMP}$ est la puissance active linéique dans la conduite.

Par ailleurs, les inventeurs ont constaté que, dans le cas de matériaux homogènes et linéaires comme dans le cas de matériaux ferromagnétiques non linéaires (comme l'acier au carbone), pour des champs magnétiques de même amplitude, la profondeur de peau du courant orbital qui se développe par la bobine d'induction est la même que celle d'un courant alternatif axial utilisé pour chauffer une conduite selon le procédé DEH (ou chauffage électrique direct).

Or, pour une conduite chauffée par le procédé DEH, il a été établi que la résistance électrique linéique en courant alternatif $R_{AC_DEH}$ est donnée par l'équation suivante :

[Math. 5]

$$R_{AC_DEH} = \frac{\rho}{\pi.OD.\delta_{DEH}}$$

Aussi, en substituant la valeur d'épaisseur de peau $\delta_{JIMP}$ calculée précédemment dans l'expression ci-dessus de la valeur de la résistance électrique linéique en courant alternatif $R_{AC_DEH}$, on obtient l'équation suivante :

[Math. 6]

$$R_{AC_DEH} = \frac{\rho}{\pi.OD.\delta_{DEH}} = \frac{\rho}{\pi.OD.\delta_{JIMP}} = \frac{2.\Pi_{heat_JIMP}}{(\pi.OD.H_{JIMP})^{2}}$$

La résistance électrique linéique en courant alternatif $R_{AC_DEH}$ de la portion de conduite soumise au champ magnétique $H_{JIMP}$ est alors donnée par l'équation suivante :

[Math. 7]

$$R_{AC_DEH} = \frac{2.\,\Pi_{heat_JIMP}}{(\pi.\,OD.\,H_{JIMP})^2}$$

Dans cette équation, $\Pi_{heat_JIMP}$ est la puissance active linéique dans la conduite et $H_{JIMP}$ est l'amplitude du champ magnétique dans l'espace annulaire compris entre la bobine d'induction et la conduite.

La figure 3 montre un exemple de distribution de l'amplitude du champ magnétique H (mesurée en Weber) produit au cours du procédé selon l'invention dans une portion de conduite 4 et dans la bobine d'induction 6 du dispositif selon l'invention, ce champ magnétique ayant été généré au moyen d'un dispositif selon l'invention tel que décrit précédemment.

Les inventeurs ont constaté que plus la distance entre les collerettes 8b de la culasse 8 et la face (interne ou externe) de la portion de conduite 4 est faible, plus le confinement du champ magnétique sur la surface de la portion de conduite est efficace. Ainsi, sur l'exemple de la figure 3 dans lequel l'entrefer est proche de 0, l'amplitude du champ magnétique H est relativement homogène sur toute la surface de la portion de conduite comprise entre les deux collerettes de la culasse du dispositif.

Comme décrit précédemment, afin de minimiser d'éventuels effets de bord dus au jeu entre les collerettes de la culasse et la portion de conduite, l'enroulement du fil conducteur composant la bobine d'induction du dispositif pourra présenter une densité plus importante au niveau des deux collerettes de la culasse du dispositif.

La figure 4 représente un exemple de distribution de la puissance active volumique $P_{heat}$ dissipée (mesurée en $W/m^3$) dans la bobine d'induction et dans une portion de conduite soumise au procédé selon l'invention. Cette puissance active peut être mesurée au moyen d'un un appareil de mesure de la puissance active, par exemple d'un analyseur de réseau branché aux bornes de la bobine d'induction.

Ici également on constate que la puissance active dissipée est essentiellement concentrée dans la portion de conduite soumise au dispositif selon l'invention.

A partir de ces mesures, le procédé selon l'invention prévoit de déterminer par calcul (voir l'équation 6) la résistance électrique linéique en régime alternatif $R_{AC_JIMP}$ de la portion de conduite.

Les figures 5 et 6 sont des exemples de courbes représentant des résistances électriques linéiques en régime alternatif (en $\mu\Omega/m$) en fonction de l'amplitude du champ magnétique (en A/m), d'une part pour un dispositif positionné à l'extérieur de la conduite (figure 5 - correspondant à la configuration du mode de réalisation de la figure 2), et d'autre part pour un dispositif positionné à l'intérieur de la conduite (figure 6 - correspondant à la configuration du mode de réalisation de la figure 1).

On notera que la détermination de la résistance électrique linéique en régime alternatif selon le procédé conforme à l'invention pourra être réalisée sur toute la longueur d'une conduite en déplaçant le dispositif le long de l'axe longitudinal de la conduite et en réitérant les étapes précédemment décrites.

On notera également que la résistance électrique linéique en régime alternatif pourra être déterminée en fonction de la profondeur de peau en faisant varier la fréquence du courant électrique alimentant la bobine d'induction. Par exemple, en faisant varier cette fréquence de 5 Hz à 10 kHz, il est possible de déterminer la résistance électrique linéique de la conduite de 0,1 mm à 20 mm de profondeur de peau.

On notera encore que l'amplitude du champ magnétique $H_{JIMP}$ sous la bobine d'induction qui est nécessaire pour déterminer la résistance électrique linéique en régime alternatif $R_{AC_JIMP}$ de la portion de conduite pourra être mesurée par une sonde ou bien être déduite d'une mesure du courant i dans la bobine d'induction à l'aide de l'équation suivante : $H_{JIMP} = n \times i / lg$ dans laquelle n est le nombre de spires de la bobine d'induction et lg est sa longueur.

Par ailleurs, pour minimiser l'influence des effets de bord sur la qualité de la mesure, les inventeurs ont proposé plusieurs systèmes possibles pour refermer le jeu qui existe nécessairement entre les collerettes de la culasse et la portion de conduite dont les tolérances dimensionnelles peuvent être larges. En effet, ce jeu dégrade le confinement du champ magnétique dans l'entrefer, et perturbe le flux magnétique circulant dans la culasse et la conduite.

Les figures 7A et 7B représentent un exemple de réalisation d'un système pour minimiser l'influence des effets de bord sur la qualité de la mesure. Dans cet exemple, ce système est basé sur l'utilisation de plaquettes 10 en matériau ferromagnétique qui sont aptes à glisser radialement sur chaque collerette 8b de la culasse 8 afin de venir en contact de la surface (ici extérieure) de la portion de conduite. De la sorte, ces plaquettes 10 forment un pontage de champ au-dessus du jeu existant entre les collerettes de la culasse et la portion de conduite.

Plus précisément, les plaquettes 10, par exemple au nombre de douze, forment un anneau lorsqu'elles sont mises bout à bout autour de l'axe X-X de la conduite (voir la figure 7B). Ces plaquettes sont logées dans une rainure annulaire 12 délimitée entre les collerettes 8b respectives de la culasse et des brides annulaires 14 (par exemple en plastique) qui sont assemblées contre ces collerettes. Un joint torique 16 positionné autour des plaquettes 12 permet de mettre sous tension ces dernières pour les mettre en appui radial contre la surface de la conduite.

Un autre exemple de réalisation de ce système pour minimiser l'influence des effets de bord représenté par les figures 8A et 8B consiste en l'utilisation de lames flexibles feuilletées 18 en matériau ferromagnétique qui remplacent les collerettes de la culasse.

Comme représenté sur les figures 8A et 8B, ces lames flexibles 18 sont positionnées à chaque extrémité du corps tubulaire 8a de la bobine d'induction et en étoile autour de la conduite afin de prendre appui radialement sur la surface de celle-ci. La flexion plus ou moins importante des lames permet d'absorber le jeu variable en fonction des tolérances de la conduite.

Dans une variante de ce système représentée par la figure 9, les lames peuvent être remplacées par un anneau 20 (ou des segments d'anneau) en matériau ferromagnétique qui est gonflable. Plus précisément, comme représenté dans la partie inférieure de la figure 9, l'anneau 20 est apte à se gonfler pour venir en appui radial contre la surface de la conduite 4.

Dans une autre variante de ce système représentée par la figure 10, les lames sont remplacées par un anneau 22 (ou des segments d'anneau) en matériau ferromagnétique qui est expansible. Comme représenté dans la partie inférieure de la figure 10, l'anneau 22 est apte à s'expanser pour venir en appui radial contre la surface de la conduite 4.

Dans encore une autre variante de ce système représentée par la figure 11, les lames sont remplacées par un anneau 24 (ou des segments d'anneau) en matériau ferromagnétique qui est creux et flexible. Comme représenté dans la partie inférieure de la figure 11, l'anneau 24 est apte à se déployer pour venir en appui radial contre la surface de la conduite 4.

Dans encore une autre variante de ce système représentée par la figure 12, les lames sont remplacées par un anneau 26 (ou des segments d'anneau) en matériau ferromagnétique qui est ondulé et flexible. Comme représenté dans la partie inférieure de la figure 12, l'anneau 26 est apte à se déployer pour venir en appui radial contre la surface de la conduite 4.

## Revendications

1. Procédé de détermination de la résistance électrique linéique en régime alternatif d'une conduite en acier, **caractérisé en ce qu'**il comprend les étapes de :

   a) génération dans une portion (4) de la conduite d'un courant induit résultant de la production d'un champ magnétique à une fréquence prédéfinie au moyen d'une bobine d'induction (6) centrée sur un axe longitudinal (X-X) de la conduite et parcourue par un courant alternatif, la bobine d'induction étant logée dans une culasse (8) en matériau ferromagnétique afin de confiner le champ magnétique sur une surface prédéfinie de la portion de conduite ;
   b) mesure de la puissance active ($P_{heat}$) dissipée par la portion de conduite soumise au champ magnétique ;
   c) détermination de l'amplitude (H) du champ magnétique produit ; et
   d) détermination de la résistance électrique linéique en régime alternatif de la portion de conduite à partir des mesures de la puissance active dissipée et de l'amplitude du champ magnétique induit, la résistance électrique linéique en régime alternatif de la portion de conduite étant déterminée à l'étape d) par l'équation : $R_{AC_DEH} = (2 \text{ x } \Pi_{heat_JIMP}) / (\pi \times OD \times H_{JIMP})^2$ ; dans laquelle $R_{AC_DEH}$ est la résistance électrique en régime alternatif, $\Pi_{Heat_JIMP}$ est la puissance active dissipée par unité de longueur de la conduite, OD est le diamètre de la conduite, et $H_{JIMP}$ est l'amplitude du champ magnétique produit.

2. Procédé selon la revendication 1, dans lequel la fréquence du champ magnétique produit à l'étape a) varie afin de déterminer la résistance électrique linéique en régime alternatif de la portion de conduite à différentes fréquences.

3. Procédé selon l'une des revendications 1 et 2, dans lequel les étapes a) à d) sont répétées sur toute la longueur de la conduite en déplaçant la bobine d'induction le long de la conduite.

4. Procédé selon l'une quelconque des revendications 1 à 3, dans lequel la bobine d'induction de l'étape a) est disposée à l'intérieur de la conduite.

5. Procédé selon l'une quelconque des revendications 1 à 3, dans lequel la bobine d'induction de l'étape a) est disposée à l'extérieur de la conduite.

6. Procédé selon l'une quelconque des revendications 1 à 5, dans lequel la fréquence du champ magnétique produit à l'étape a) est comprise entre 5 Hz et 10 kHz.

**7.** Dispositif (2 ; 2') pour la mise en œuvre du procédé selon l'une quelconque des revendications 1 à 6, comprenant une conduite sous-marine (4) réalisée en acier et destinée à transporter des fluides tels que du pétrole et du gaz, une bobine d'induction (6 ; 6') destinée à être centrée sur un axe longitudinal (X-X) de la conduite (4) et à être parcourue par un courant alternatif, une culasse (8 ; 8') en matériau ferromagnétique à l'intérieur de laquelle est montée la bobine d'induction afin de confiner le champ magnétique sur une surface prédéfinie de la portion de conduite, et un appareil de mesure de la puissance active branché aux bornes de la bobine d'induction pour mesurer la puissance active ($P_{heat}$) dissipée par la portion de conduite soumise au champ magnétique.

**8.** Dispositif selon la revendication 7, dans lequel la culasse (8 ; 8') comprend un corps tubulaire (8a ; 8'a) concentrique à la bobine d'induction qui se termine à chaque extrémité par une collerette (8b ; 8'b) annulaire délimitant un entrefer avec la portion de la conduite.

**9.** Dispositif selon l'une des revendications 7 et 8, dans lequel la bobine d'induction est réalisée par un enroulement d'un fil conducteur avec un pas variable sur la longueur de ladite bobine d'induction.

**10.** Dispositif selon l'une des revendications 7 et 8, dans lequel la bobine d'induction est réalisée par un enroulement en plusieurs couches de fils conducteurs sur tout ou partie de sa longueur.

**11.** Dispositif selon l'une quelconque des revendications 7 à 10, comprenant en outre des moyens (10 ; 18 ; 20 ; 22 ; 24 ; 26) pour minimiser l'influence des effets de bord sur la qualité des mesures.

**12.** Dispositif selon la revendication 11, comprenant des plaquettes (10) en matériau ferromagnétique qui sont aptes à glisser radialement sur chaque collerette (8b) de la culasse (8) afin de venir en contact de la surface de la portion de conduite pour minimiser l'influence des effets de bord sur la qualité des mesures.

**13.** Dispositif selon la revendication 11, comprenant des lames flexibles feuilletées (18) en matériau ferromagnétique qui sont positionnées en étoile autour de la conduite et à chaque extrémité du corps tubulaire de la bobine d'induction afin de venir en contact de la surface de la portion de conduite pour minimiser l'influence des effets de bord sur la qualité des mesures.

## Patentansprüche

**1.** Verfahren zum Bestimmen des linearen elektrischen Wechselstromwiderstands einer Stahlleitung, **dadurch gekennzeichnet, dass** es die folgenden Schritte umfasst:

a) Erzeugen eines induzierten Stroms in einem Abschnitt (4) der Leitung, der aus der Erzeugung eines Magnetfelds mit einer vordefinierten Frequenz mittels einer Induktionsspule (6) resultiert, die auf einer Längsachse (X-X) der Leitung zentriert ist und von einem Wechselstrom durchflossen wird, wobei die Induktionsspule in einem Joch (8) aus ferromagnetischem Material untergebracht ist, um das Magnetfeld auf eine vordefinierte Fläche des Leitungsabschnitts einzugrenzen;
b) Messen der Wirkleistung ($P_{heat}$), die von dem Leitungsabschnitt abgeleitet wird, der dem Magnetfeld ausgesetzt ist;
c) Bestimmen der Amplitude (H) des erzeugten Magnetfelds; und
d) Bestimmen des linearen elektrischen Wechselstromwiderstands des Leitungsabschnitts anhand der Messungen der abgeleiteten aktiven Wirkleistung und der Amplitude des induzierten Magnetfelds, wobei der lineare elektrische Wechselstromwiderstand des Leitungsabschnitts in Schritt
d) durch die Gleichung: $R_{AC_DEH} = (2 \times \Pi heat_JIMP) / (\pi \times OD \times H_{JIMP})^2$ bestimmt wird; wobei $R_{AC_DEH}$ der elektrische Wechselstromwiderstand ist, $\Pi_{heat_JIMP}$ die abgeleitete Wirklleistung pro Längeneinheit der Leitung ist, OD der Durchmesser der Leitung ist und $H_{JIMP}$ die Amplitude des erzeugten Magnetfelds ist.

**2.** Verfahren nach Anspruch 1, wobei die Frequenz des in Schritt a) erzeugten Magnetfelds variiert wird, um den linearen elektrischen Wechselstromwiderstand des Leitungsabschnitts bei verschiedenen Frequenzen zu bestimmen.

**3.** Verfahren nach einem der Ansprüche 1 und 2, wobei die Schritte a) bis d) über die gesamte Länge der Leitung wiederholt werden, indem die Induktionsspule entlang der Leitung bewegt wird.

**4.** Verfahren nach einem der Ansprüche 1 bis 3, wobei die Induktionsspule von Schritt a) im Inneren der Leitung angeordnet ist.

5. Verfahren nach einem der Ansprüche 1 bis 3, wobei die Induktionsspule aus Schritt a) außerhalb der Leitung angeordnet ist.

6. Verfahren nach einem der Ansprüche 1 bis 5, wobei die Frequenz des in Schritt a) erzeugten Magnetfelds in einem Bereich von 5 Hz bis 10 kHz ist.

7. Vorrichtung (2; 2') zum Durchführen des Verfahrens nach einem der Ansprüche 1 bis 6, umfassend eine Unterwasserleitung (4) aus Stahl zum Transport von Fluiden, wie beispielsweise Öl und Gas, eine Induktionsspule (6; 6'), die dazu bestimmt ist, auf eine Längsachse (X-X) der Leitung (4) zentriert zu sein und von einem Wechselstrom durchflossen zu werden, ein Joch (8; 8') aus ferromagnetischem Material, in dem die Induktionsspule montiert ist, um das Magnetfeld auf eine vordefinierte Fläche des Leitungsabschnitts zu begrenzen, und ein Wirkleistungsmessgerät, das an die Klemmen der Induktionsspule angeschlossen ist, um die Wirkleistung ($P_{heat}$) zu messen, die von dem Leitungsabschnitt abgeleitet wird, der dem Magnetfeld ausgesetzt ist.

8. Vorrichtung nach Anspruch 7, wobei das Joch (8; 8') einen rohrförmigen Körper (8a; 8'a) umfasst, der konzentrisch zu der Induktionsspule ist und an jedem Ende in einem ringförmigen Bund (8b; 8'b) endet, der einen Spalt mit dem Abschnitt der Leitung begrenzt.

9. Vorrichtung nach einem der Ansprüche 7 oder 8, wobei die Induktionsspule durch eine Wicklung aus einem leitenden Draht mit einer variablen Steigung über die Länge der Induktionsspule hergestellt wird.

10. Vorrichtung nach einem der Ansprüche 7 oder 8, wobei die Induktionsspule durch eine mehrlagige Wicklung aus leitenden Drähten über ihre gesamte Länge oder einen Teil ihrer Länge hergestellt ist.

11. Vorrichtung nach einem der Ansprüche 7 bis 10, ferner umfassend Einrichtungen (10; 18; 20; 22; 24; 26), um den Einfluss von Randeffekten auf die Qualität der Messungen zu minimieren.

12. Vorrichtung nach Anspruch 11, umfassend Plättchen (10) aus ferromagnetischem Material, die geeignet sind, radial über jeden Flansch (8b) des Jochs (8) zu gleiten, um mit der Oberfläche des Leitungsabschnitts in Kontakt zu kommen, um den Einfluss von Randeffekten auf die Qualität der Messungen zu minimieren.

13. Vorrichtung nach Anspruch 11, umfassend flexible laminierte Lamellen (18) aus ferromagnetischem Material, die sternförmig um die Leitung und an jedem Ende des rohrförmigen Körpers der Induktionsspule positioniert sind, um die Oberfläche des Leitungsabschnitts zu berühren, um den Einfluss von Randeffekten auf die Qualität der Messungen zu minimieren.

## Claims

1. A method for determining the linear electrical resistance in AC mode of a steel pipeline, **characterized in that** it comprises the steps of:

   a) generating in a portion (4) of the pipeline an induced current resulting from the production of a magnetic field at a predefined frequency by means of an induction coil (6) centered on a longitudinal axis (X-X) of the pipeline and traversed by an AC current, the induction coil being housed in a yoke (8) made of ferromagnetic material in order to confine the magnetic field to a predefined surface of the pipeline portion;
   b) measuring the active power ($P_{heat}$) dissipated by the pipeline portion subjected to the magnetic field;
   c) determining the amplitude (H) of the produced magnetic field; and
   d) determining the linear electrical resistance in AC mode of the pipeline portion from the measurements of the dissipated active power and the amplitude of the induced magnetic field, the linear electrical resistance in AC mode of the pipeline portion being determined in step d) by the equation: $R_{AC_DEH} = (2 \times \Pi_{heat_JIMP}) / (\pi \times OD \times H_{JIMP})^2$; where $R_{AC_DEH}$ is the electrical resistance in AC mode, $\Pi_{heat_JIMP}$ is the active power dissipated per unit length of the pipeline, OD is the diameter of the pipeline, and $H_{JIMP}$ is the amplitude of the produced magnetic field.

2. The method according to claim 1, wherein the frequency of the magnetic field produced in step a) varies in order to determine the linear electrical resistance in AC mode of the pipeline portion at different frequencies.

3. The method according to any of claims 1 and 2, wherein steps a) to d) are repeated over the entire length of the pipeline by moving the induction coil along the pipeline.

4. The method according to any one of claims 1 to 3, wherein the induction coil of step a) is disposed inside the pipeline.

5. The method according to any one of claims 1 to 3, wherein the induction coil of step a) is disposed outside the pipeline.

6. The method according to any one of claims 1 to 5, wherein the frequency of the magnetic field produced in step a) is comprised between 5 Hz and 10 kHz.

7. A device (2; 2') for implementing the method according to any one of claims 1 to 6, comprising a subsea pipeline (4) made of steel and intended to transport fluids such as oil and gas, an induction coil (6; 6') intended to be centered on a longitudinal axis (X-X) of the pipeline (4) and to be traversed by an AC current, a yoke (8; 8') made of ferromagnetic material inside which the induction coil is mounted in order to confine the magnetic field to a predefined surface of the pipeline portion, and an apparatus for measuring the active power connected to the terminals of the induction coil to measure the active power ($P_{heat}$) dissipated by the pipeline portion subjected to the magnetic field.

8. The device according to claim 7, wherein the yoke (8; 8') comprises a tubular body (8a; 8'a) concentric with the induction coil which terminates at each end in an annular collar (8b; 8'b) delimiting an air gap with the portion of the pipeline.

9. The device according to any of claims 7 and 8, wherein the induction coil is made by winding of a conductive wire with a variable pitch over the length of said induction coil.

10. The device according to any of claims 7 and 8, wherein the induction coil is made by winding of conductive wires in several layers over all or part of its length.

11. The device according to any one of claims 7 to 10, further comprising means (10; 18; 20; 22; 24; 26) for minimizing the influence of the edge effects on the quality of the measurements.

12. The device according to claim 11, comprising plates (10) made of ferromagnetic material which are able to radially slide on each collar (8b) of the yoke (8) in order to come into contact with the surface of the pipeline portion to minimize the influence of the edge effects on the quality of the measurements.

13. The device according to claim 11, comprising laminated flexible blades (18) made of ferromagnetic material which are positioned in a star configuration around the pipeline and at each end of the tubular body of the induction coil in order to come into contact with the surface of the pipeline portion to minimize the influence of the edge effects on the quality of the measurements.

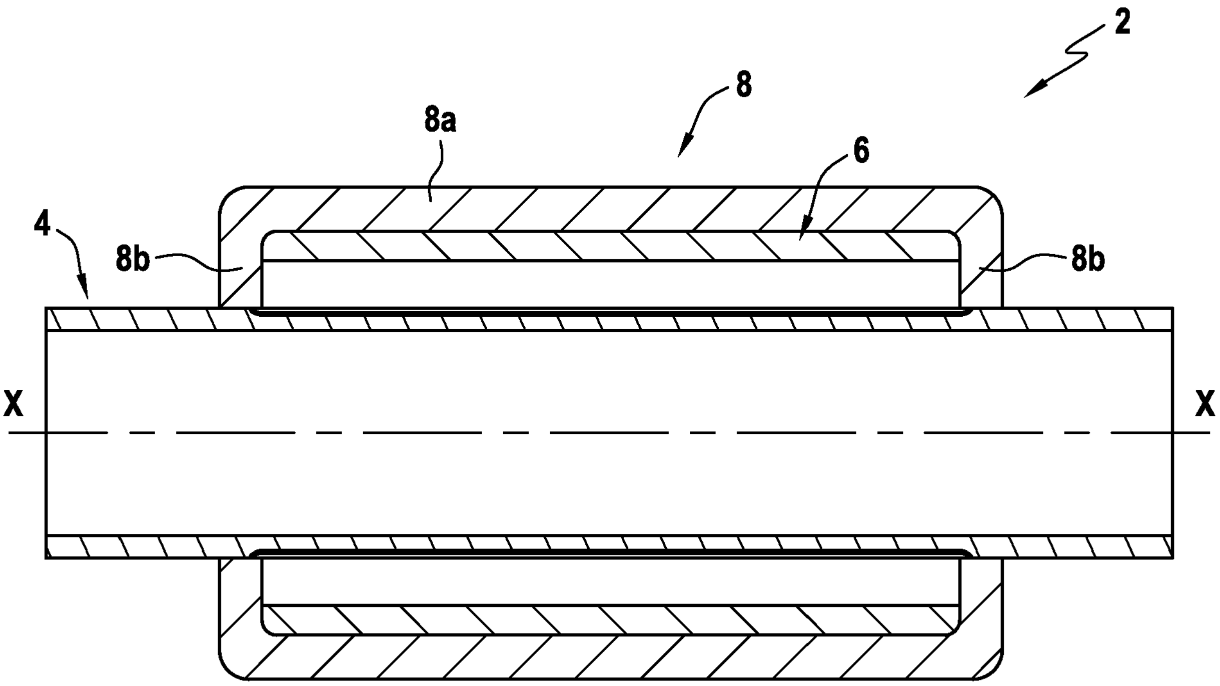


FIG.1

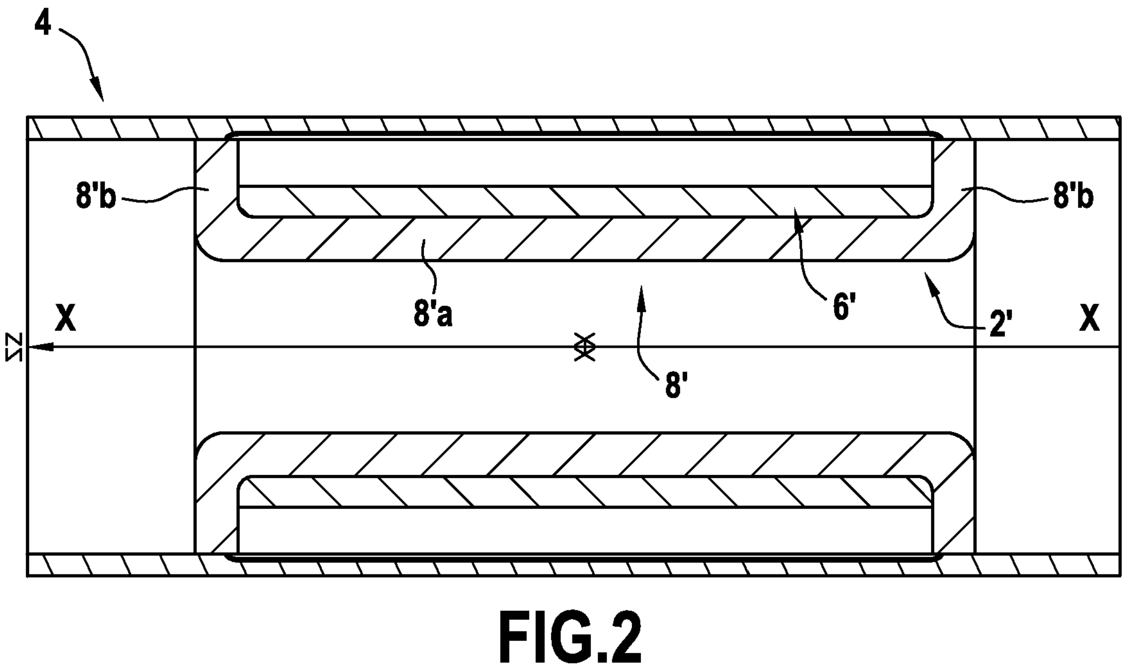


FIG.2

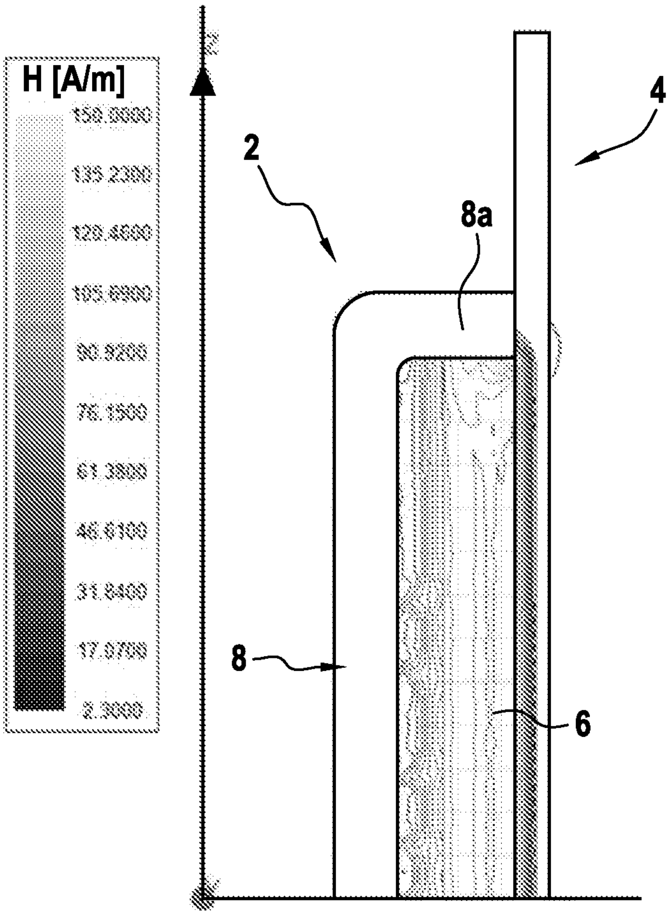
H [A/m]
150.0000
135.2300
120.4600
105.6900
90.9200
76.1500
61.3800
46.6100
31.8400
17.0700
2.3000
2
4
8a
8
6

FIG.3

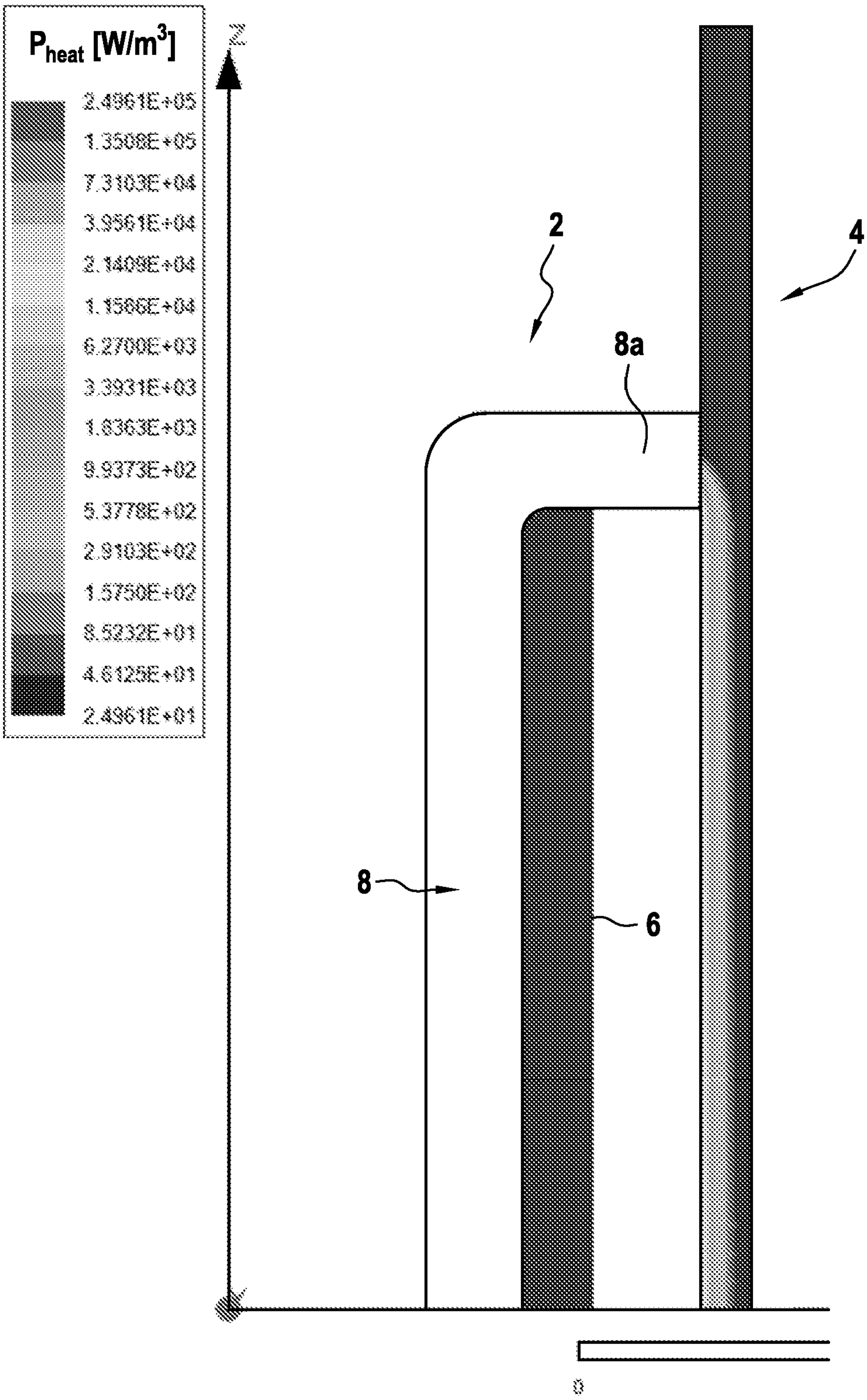

P_heat [W/m³]
2.4961E+05
1.3508E+05
7.3103E+04
3.9561E+04
2.1409E+04
1.1586E+04
6.2700E+03
3.3931E+03
1.8363E+03
9.9373E+02
5.3778E+02
2.9103E+02
1.5750E+02
8.5232E+01
4.6125E+01
2.4961E+01
Z
2
4
8a
8
6
0


FIG.4

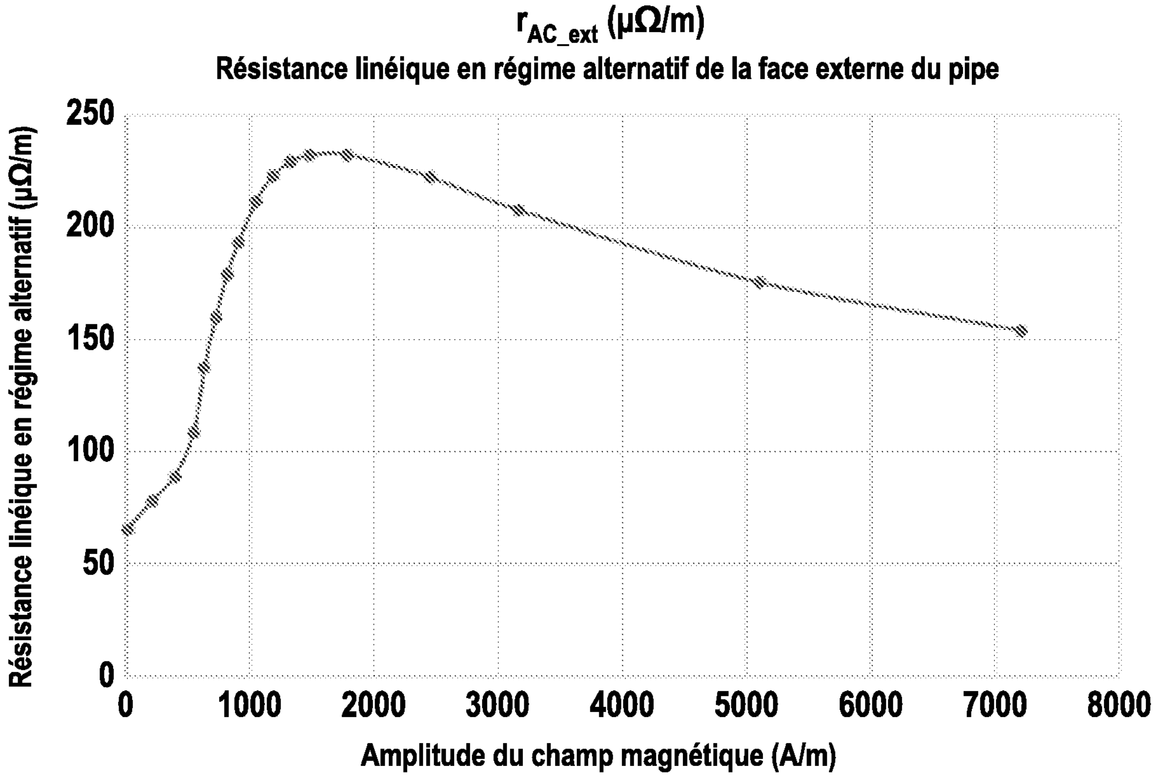
$r_{AC_ext}$ (μΩ/m)
Résistance linéique en régime alternatif de la face externe du pipe
Résistance linéique en régime alternatif (μΩ/m)
250
200
150
100
50
0
0
1000
2000
3000
4000
5000
6000
7000
8000
Amplitude du champ magnétique (A/m)

FIG.5

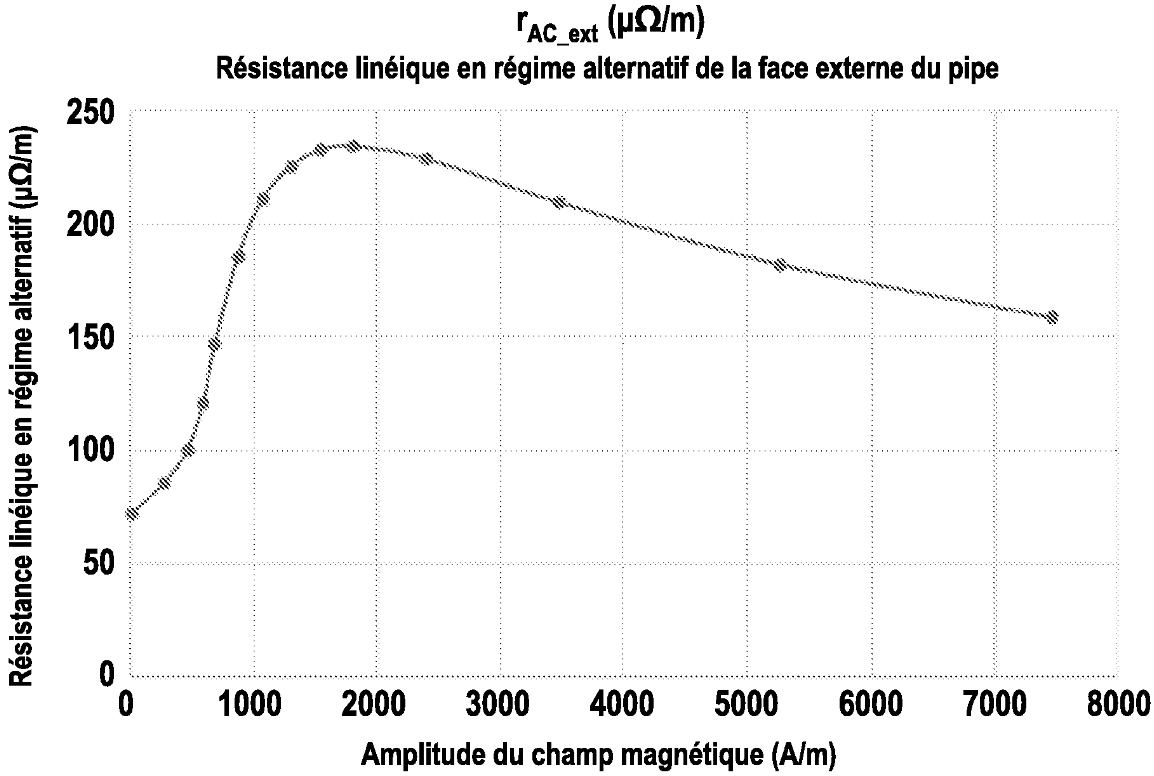
$r_{AC_ext}$ (μΩ/m)
Résistance linéique en régime alternatif de la face externe du pipe
Résistance linéique en régime alternatif (μΩ/m)
250
200
150
100
50
0
0
1000
2000
3000
4000
5000
6000
7000
8000
Amplitude du champ magnétique (A/m)

FIG.6

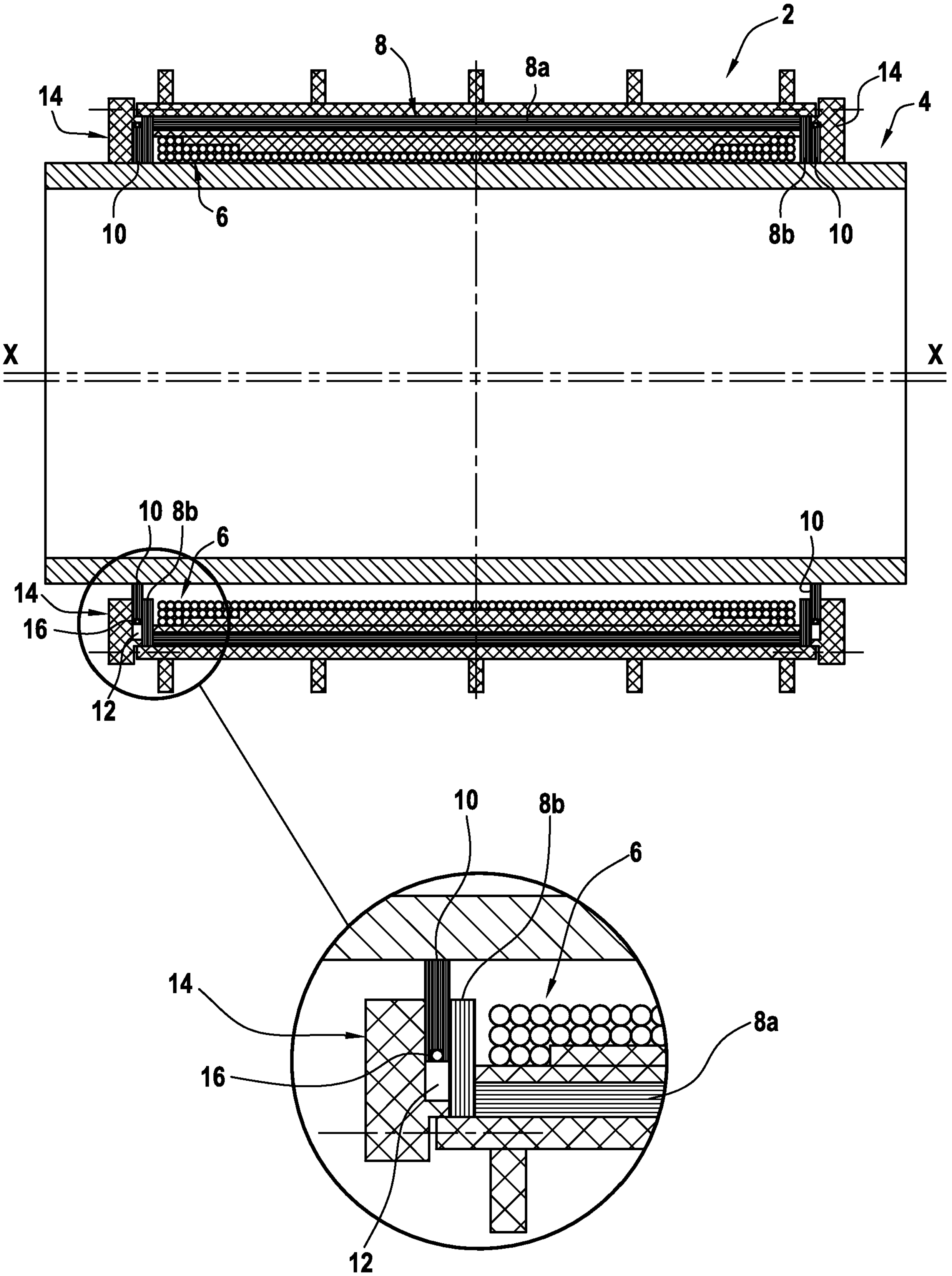


FIG.7A

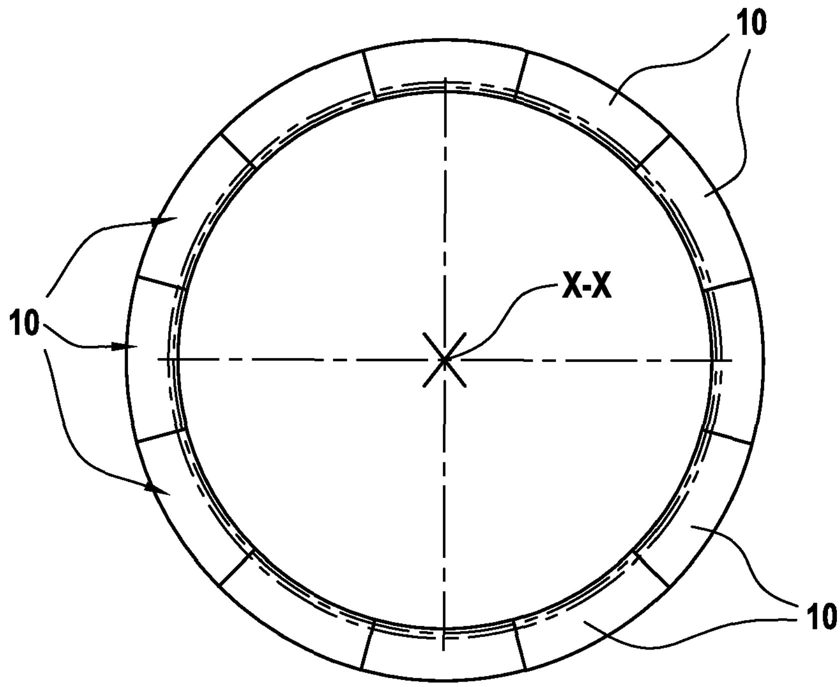


FIG.7B

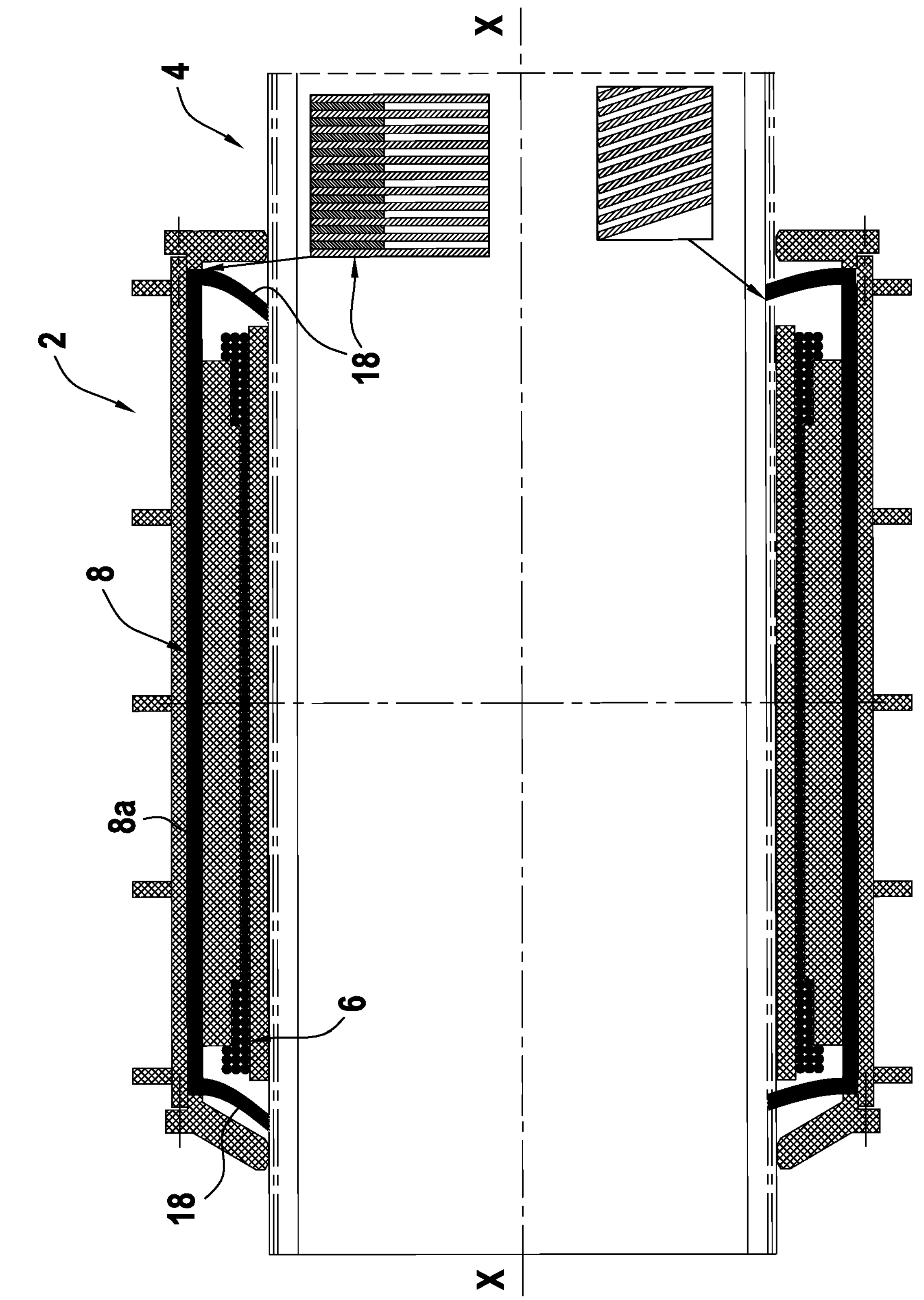


FIG.8A

[Fig.8B]

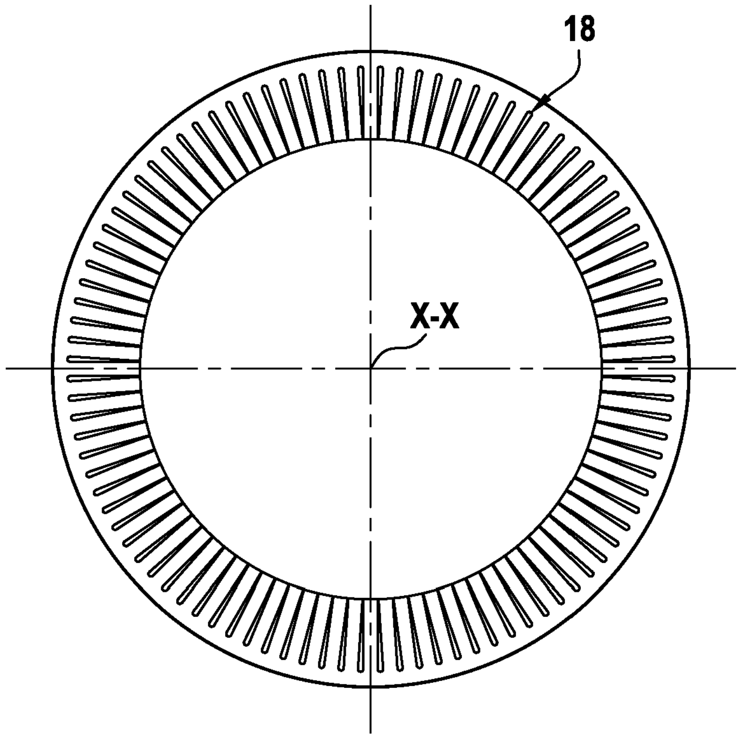


FIG.8B

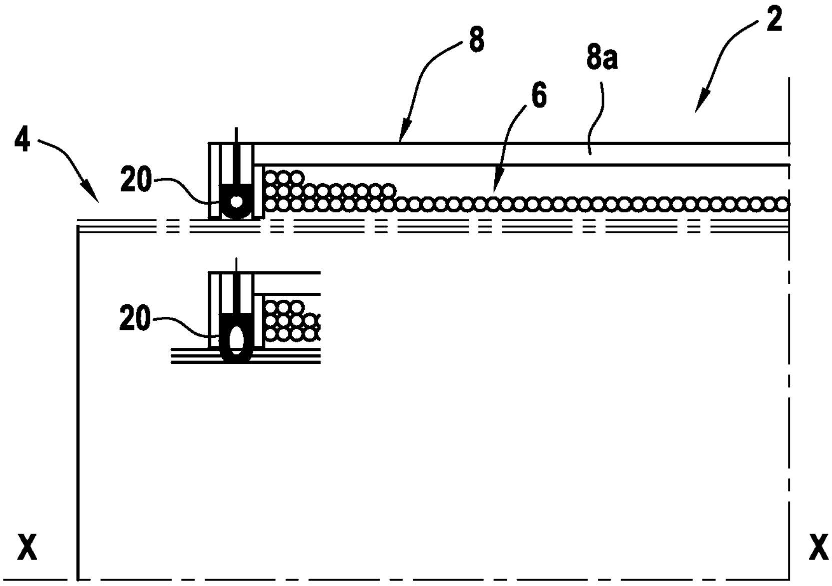


FIG.9

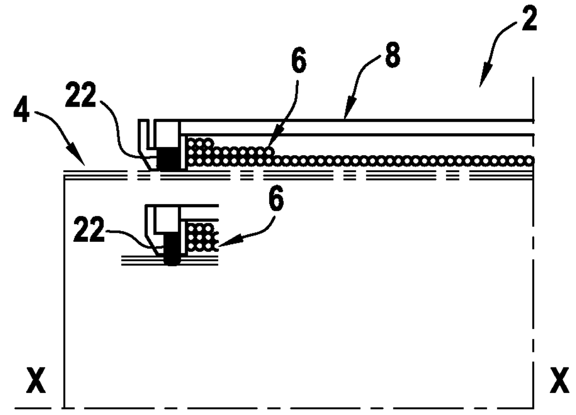


FIG.10

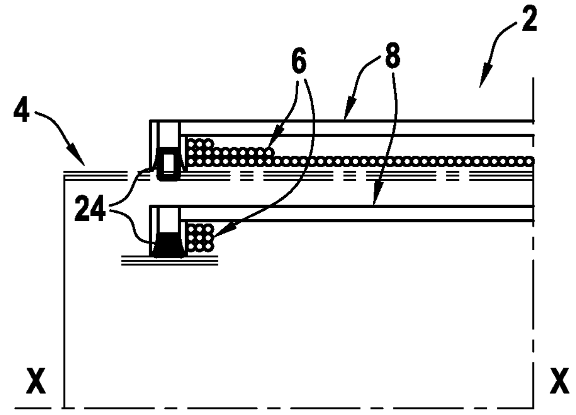


FIG.11

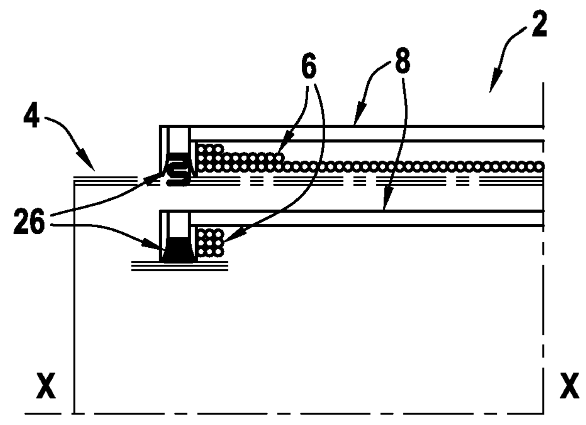


FIG.12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- EP 0375375 A


### Littérature non-brevet citée dans la description


- Electromagnetic Modelling for Electrical Heating of Pipelines. *International Society of Offshore and Polar Engineers*, 2007